(19) Europäisches Patentamt

European Patent Office

Office européen des brevets

(11) **EP 2 037 453 B1**

(12) **EUROPEAN PATENT SPECIFICATION**

(45) Date of publication and mention
of the grant of the patent:
**21.07.2010 Bulletin 2010/29**

(21) Application number: **08015838.9**

(22) Date of filing: **09.09.2008**

(51) Int Cl.:
*G11B 5/855* (2006.01)   *G03F 7/00* (2006.01)
*G11B 5/596* (2006.01)   *B29C 33/42* (2006.01)
*B29C 45/26* (2006.01)   *H01L 21/027* (2006.01)

(54) **Imprint mold structure, imprinting method using the same, and magnetic recording medium**

Druckformstruktur, Druckverfahren damit und magnetisches Aufzeichnungsmedium

Structure de moule d'impression, procédé d'impression l'utilisant et moyen d'enregistrement magnétique

(84) Designated Contracting States:
**DE GB**

(30) Priority: **13.09.2007 JP 2007238031**

(43) Date of publication of application:
**18.03.2009 Bulletin 2009/12**

(73) Proprietor: **FUJIFILM Corporation**
**Tokyo 106-8620 (JP)**

(72) Inventors:
• **Nishikawa, Masakazu c/o FUJIFILM**
**CORPORATION**
**Kanagawa (JP)**

• **Wakamatsu, Satoshi c/o FUJIFILM**
**CORPORATION**
**Kanagawa (JP)**

(74) Representative: **HOFFMANN EITLE**
**Patent- und Rechtsanwälte**
**Arabellastrasse 4**
**81925 München (DE)**

(56) References cited:
**EP-A- 1 492 090      EP-A- 1 830 351**
**JP-A- 2004 177 783   US-A1- 2002 031 074**
**US-A1- 2006 098 319   US-A1- 2006 176 606**
**US-A1- 2006 193 083   US-A1- 2006 198 052**
**US-A1- 2006 203 386**

EP 2 037 453 B1

**Description**

BACKGROUND OF THE INVENTION

Field of the Invention

The present invention relates to an imprint mold structure, an imprinting method using the imprint mold structure, and a magnetic recording medium.

Description of the Related Art

In recent years, hard disc drives that are excellent in speed and cost performance characteristics have begun to be mounted in portable devices such as cellular phones, compact acoustic devices and video cameras as major storage devices.

Furthermore, with increase in market share of hard disc drives as recording devices mounted in portable devices, hard disc drives are requested to meet the demand for further sizing down and increasing capacity, for which it is necessary to develop a technique for increasing recording density.

The recording density of hard disc drives has been conventionally increased by narrowing spaces between data tracks in a magnetic recording medium and by narrowing the magnetic head width.

However, by narrowing spaces between data tracks, effects of magnetism between adjacent tracks (crosstalk) and effects of heat fluctuation become noticeable, thus there is a limitation on improvements in the recording density by the method of narrowing spaces between data tracks.

On the other hand, there is also a limitation on improvements in the surface recording density by the method of narrowing the magnetic head width.

Accordingly, magnetic recording media referred to as discrete track media have been proposed as a solution to noise caused by crosstalk. In the discrete track media, magnetic interference between adjacent tracks is decreased by providing discrete structures in which nonmagnetic guard band regions are provided between adjacent tracks so as to magnetically separate tracks from one another.

Also, magnetic recording media referred to as patterned media, in which bits for recording signals are provided in predetermined patterns of shape, have been proposed as a solution to demagnetization caused by heat fluctuation.

As a method for manufacturing the discrete track media or the patterned media, an imprinting method (imprint process) is used in which a desired pattern is transferred onto a resist layer formed on a surface of a magnetic recording medium by using a resist pattern forming mold (otherwise referred to as "mold") (see Japanese Patent Application Laid-Open (JP-A) No. 2004-221465).

The imprinting method is specifically a method of coating a substrate to be processed with a thermoplastic resin or a photocurable resin as an imprint resist, firmly attaching and pressing a mold that has been processed in a desired pattern to the resin covering the substrate, curing the resin by heating/cooling or exposing the resin to light, forming a pattern corresponding to the pattern of the mold on the resin by separating the mold from the resin, and patterning the substrate by dry etching or wet etching using the above pattern on the resist as a mask, to obtain the desired magnetic recording medium.

Various improvements of the imprinting method are challenged to form ultrafine patterns on discrete media or patterned media (see JP-A Nos.2006-120299 and 2005-71487).

In pattern formation on a discrete medium or a patterned medium by the above method, a uniform pattern can be formed well with respect to a narrow partial area of the entire area of a medium, however, it is difficult to form a uniform pattern over a wide area of a medium such as the entire area of a medium.

This may lead to a decreased yield of magnetic recording media and significantly degraded performance of the magnetic recording media.

Thus also in order not to invite the above mentioned results, a method is requested in which a pattern is transferred uniformly over a wide area of a magnetic recording medium and a magnetic recording medium is efficiently manufactured thereby.

BRIEF SUMMARY OF THE INVENTION

The present invention is carried out in view of such present state of the art, and aims to solve the problems in the prior art and to achieve the following object. Namely an object of the present invention is to provide an imprint mold structure which can uniformly and efficiently transfer a pattern by enhancing flow of a composition of an imprint resist layer when the imprint mold structure is pressed against the imprint resist layer, an imprinting method in which transfer accuracy is improved by using the imprint mold structure, and a magnetic recording medium of improved recording property and reproduction property.

Having earnestly investigated, the present inventors found that in order to enhance flow of a composition forming an imprint resist layer when an imprint mold structure is pressed against the imprint resist layer, concavo-convex portions of a servo area formed continuously in a radial direction in the imprint mold structure may be extended to at least one of inner circumferential edge and outer circumferential edge of the concavo-convex pattern of the servo area.

The present invention is based on the above findings by the present inventors, and the following are means for solving the aforementioned problems. Namely:

<1> An imprint mold structure including at least a disc-shaped substrate having on a surface thereof concavo-convex patterns in a data area and in a servo area, wherein the concavo-convex pattern in the data area is formed by forming a plurality of convex portions along concentric circumferences on the surface of the disc-shaped substrate, and the concavo-convex pattern in the servo area is formed by radially forming ridges of a plurality of convex portions on the surface of the disc-shaped substrate, wherein the imprint mold structure is configured for transferring the concavo-convex pattern onto an imprint resist layer, which is composed of an imprint resist composition formed on a disc-shaped magnetic recording medium substrate, by pressing the concavo-convex patterns in the data area and in the servo area against the imprint resist layer, and wherein at at least one of an inner circumferential edge and an outer circumferential edge of the concavo-convex pattern in the servo area relative to the center of the disc-shaped substrate of the imprint mold structure, a dummy pattern is formed, which extends radially from at least one of an inner circumferential edge and an outer circumferential edge of a pattern forming area on the magnetic recording medium substrate.

In the imprint mold structure according to the item <1>, when a desired pattern is transferred onto an imprint resist layer formed on the magnetic recording medium substrate, the cross-sectional area of openings of flow paths of the imprint resist layer is increased by the dummy pattern to increase conductance of the imprint resist layer. This results in uniform pressure over the magnetic recording medium when the imprint mold structure is pressed against the imprint resist layer on the magnetic recording medium, in less occurrence of poor local transfer due to a shape of convex portions (pattern), and in smooth and secure transfer of the desired pattern over the entire surface of the imprint resist layer.

<2> The imprint mold structure according to the item <1>, wherein the dimension of regions of the dummy pattern in a radial direction on the imprint mold structure is in the range of 0.1 mm to 1.0 mm.

<3> The imprint mold structure according to any one of the items <1> and <2>, wherein the width of the concavo-convex pattern in the servo area along the outermost circumference (WO) is larger than the width of the concavo-convex pattern in the servo area along the innermost circumference (WI).

<4> The imprint mold structure according to any one of the items <1> to <3>, wherein the ratio of the width of the concavo-convex pattern in the servo area along the outermost circumference (WO) to the width of the concavo-convex pattern in the servo area along the innermost circumference (WI) (W: W = WO/WI) is in the range of 1.5 to 2.8.

<5> The imprint mold structure according to any one of the items <1> to <4>, wherein the number (N) of convex portions or concave portions of the servo area is in the range of 60 to 300.

<6> An imprinting method including at least transferring a concavo-convex pattern onto an imprint resist layer formed on a magnetic recording medium substrate, by pressing the imprint mold structure according to any one of the items <1> to <5> against the imprint resist layer.

<7> The imprinting method according to the item <6>, wherein conditions for the imprinting method satisfy the following Mathematical Expression 1:

$$0.001 \leq P/NW < 0.45 \qquad \text{Mathematical Expression 1}$$

wherein P represents the viscosity of the imprint resist composition, W represents the ratio of the width of the concavo-convex pattern in the servo area along the outermost circumference (WO) to the width of the concavo-convex pattern in the servo area along the innermost circumference (WI) (W = WO/WI), and N represents the number of convex portions or concave portions of the servo area.

<8> The imprinting method according to any one of the items <6> and <7>, wherein the width of the concavo-convex pattern in the servo area along the outermost circumference (WO) is larger than the width of the concavo-convex pattern in the servo area along the innermost circumference (WI).

<9> The imprinting method according to any one of the items <6> to <8>, wherein the ratio of the width of the concavo-convex pattern in the servo area along the outermost circumference (WO) to the width of the concavo-convex pattern in the servo area along the innermost circumference (WI) (W: W = WO/WI) is in the range of 1.5 to 2.8.

<10> The imprinting method according to any one of the items <6> to <9>, wherein the number (N) of convex portions or concave portions of the servo area is in the range of 60 to 300.

<11> A magnetic recording medium including at least a magnetic pattern portion and a nonmagnetic pattern portion, wherein the magnetic recording medium is manufactured by a method for manufacturing a magnetic recording medium which includes at least transferring a concavo-convex pattern onto an imprint resist layer formed on a magnetic recording medium substrate, by pressing the imprint mold structure according to any one of the items <1> to <5> against the imprint resist layer, forming on a first area of a magnetic layer the magnetic pattern portion of the data area corresponding to the concavo-convex pattern in the data area formed on the imprint mold structure and forming on a second area of the magnetic layer the magnetic pattern portion of the servo area corresponding to the concavo-convex pattern in the servo area formed on the imprint mold structure by etching the first and second area of the magnetic layer formed on a surface of the magnetic recording medium substrate using as a mask the imprint resist layer onto which the concavo-convex pattern has been transferred, and forming the nonmagnetic pattern portion by embedding a nonmagnetic material in a concave portion formed on the magnetic layer, and wherein the width of the magnetic pattern portion of the servo area along the outermost circumference (WO) is larger than the width of the magnetic pattern portion of the servo area along the innermost circumference (WI).

<12> The magnetic recording medium according the item <11>, wherein the ratio of the width of the magnetic pattern portion of the servo area along the outermost circumference (WO) to the width of the magnetic pattern portion of the servo area along the innermost circumference (WI) (W: W = WO/WI) is in the range of 1.5 to 2.8.

<13> The magnetic recording medium according to any one of the items <11> and <12>, wherein the number of magnetic pattern portions of the servo area (N) is in the range of 60 to 300.

<14> The magnetic recording medium according to any one of the items <11> to <13>, wherein the magnetic pattern portions of the servo area are servo pattern.

<15> The magnetic recording medium according to any one of the items <11> to <14>, wherein the magnetic recording medium satisfies the following Mathematical

**Expression 1:**

$$0.001 \leq P/NW < 0.45 \qquad \text{(Mathematical Expression 1)}$$

wherein P represents the viscosity of the imprint resist composition, W represents the ratio of the width of the magnetic pattern portion of the servo area along the outermost circumference (WO) to the width of the magnetic pattern portion of the servo area along the innermost circumference (WI) (W = WO/WI), and N represents the number of magnetic pattern portions of the servo area.

The present invention can provide an imprint mold structure which can efficiently and uniformly transfer a pattern by enhancing flow of a composition of the imprint resist layer when the imprint mold structure is pressed against the imprint resist layer, an imprinting method of improved transfer accuracy by using the imprint mold structure, and a magnetic recording medium of improved recording property and reproduction property.

BRIEF DESCRIPTION OF THE DRAWINGS

FIG. 1 is a plan view exemplarily showing the configuration of an imprint mold structure according to the present invention.
FIG. 2 is a partial sectional view exemplarily showing the configuration of an imprint mold structure according to the present invention.
FIG. 3A is a cross-sectional view exemplarily showing a method for manufacturing an imprint mold structure according to the present invention.
FIG. 3B is another cross-sectional view exemplarily showing the method for manufacturing an imprint mold structure according to the present invention.
FIG. 4 is a cross-sectional view exemplarily showing a method for manufacturing a magnetic recording medium using an imprint mold structure according to the present invention.

DETAILED DESCRIPTION OF THE INVENTION

An imprint mold structure according to the present invention will be described with reference to the drawings below.

(Imprint mold structure)

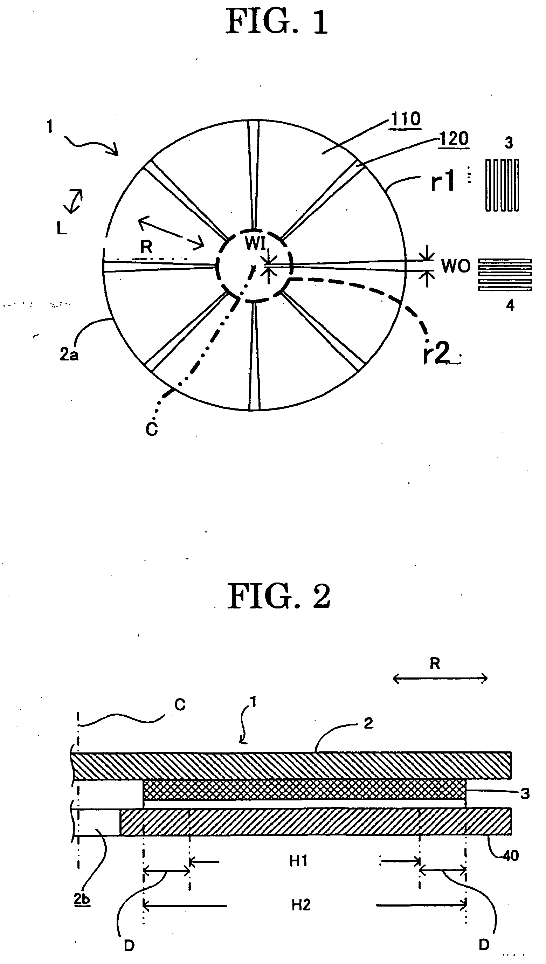

FIG. 1 is a plan view exemplarily showing the schematic configuration of an imprint mold structure according to the present invention. L denotes a circumferential direction, R denotes a radial direction, C denotes the center, r1 denotes the outside diameter, r2 denotes the inside diameter, WI denotes the width of a servo area along the innermost circumference measured based on a concavo-convex pattern in the servo area, and WO denotes the width of the servo area along the outermost circumference measured based on a concavo-convex pattern in the servo area.

FIG. 2 is a partial sectional view exemplarily showing the configuration of an imprint mold structure according to the present invention. H1 is a pattern forming area, H2 is a total pattern area, and D is a dummy pattern area.

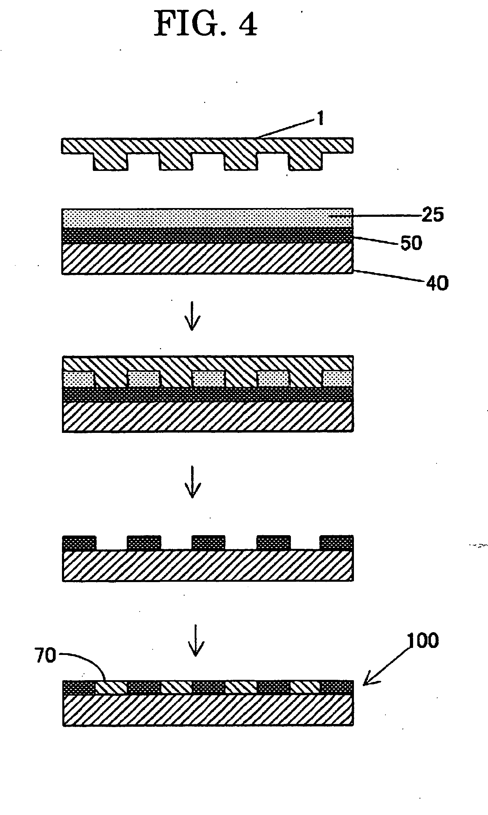

As shown in FIGS. 1 and 2, an imprint mold structure 1 includes at least a disc-shaped substrate 2, a concavo-convex pattern 3 in a data area 110 in which a plurality of convex portions are concentrically formed at predetermined intervals on a surface 2a of the substrate 2 relative to the surface 2a, and a concavo-convex pattern 4 in a servo area 120 in which a plurality of convex portions are radially placed at predetermined intervals on the surface 2a relative to the surface 2a, and other members as required, wherein the imprint mold structure 1 is used for pressing against the subject to be processed (for example, an imprint resist 25 in FIG. 4 described later).

Here, as shown in FIG. 1, each of the servo areas 120 is formed in an equiangular manner so as to provide separate data areas 110.

Furthermore, as shown in FIG. 2, at at least one of an inner circumferential edge and an outer circumferential edge of the concavo-convex pattern in the data area or the concavo-convex pattern in the servo area a dummy pattern (D), which corresponds to concavo-convex portions on a substrate of the magnetic recording medium extending radially from at least one of an inner circumferential edge and an outer circumferential edge of a pattern forming area (H1), is formed.

Note that the area of the dummy pattern (D) is, as shown in FIG. 2, set based on the position of the pattern forming area (H1) on the substrate 40 of the magnetic recording medium, with the center of the disc-shaped imprint mold structure being placed on the center of the disc-shaped magnetic recording medium substrate 40 with accuracy within $\pm$ 50 $\mu$m, by extending the dummy pattern radially. When the absolute value of the accuracy is more than 50 $\mu$m, adherence of an imprint mold structure 1 to a magnetic recording medium becomes uneven at the time of NIL (nanoimprint lithography) (adherence pressure varies in the magnetic recording medium with changes of contact area between the mold and the magnetic recording medium depending on the angle with which the mold is superimposed on the magnetic recording medium), and evenness of resist pattern degrades.

By forming the dummy pattern, the cross-sectional area of openings of flow paths of an imprint resist layer is increased to enhance conductance of the imprint resist layer. This results in uniform pressure over the magnetic recording medium when the imprint mold structure is pressed against the imprint resist layer on the magnetic recording medium, less occurrence of poor local transfer due to a shape of convex portions (pattern), and smooth and secure transfer of the desired pattern over the entire surface of the imprint resist layer.

Conventionally the concavo-convex pattern in the data area is a concentric concavo-convex pattern, and when the imprint mold is imprinted on the imprint resist layer, redundant resist flows in radial directions along the concavo-convex pattern. Thus an imprint resist pushed out by convex portions of the mold cannot flow smoothly, producing resist pools. These result in difficulty in increasing pressing pressure and in formation of a thick residual film in concave portions of the resist pattern.

In contrast to data areas, servo areas have patterns extending in a radial direction, resulting in relatively small inhibition and resistance in flow paths of an imprint resist (an imprint resist flows linearly) and in easy imprinting of excellent quality in servo areas.

Note that when there are servo areas and data areas in a magnetic recording medium, a redundant resist is produced both for the servo areas and the data areas at the time of imprinting.

Since there are sites connecting a data area to a servo area, a redundant resist in the data area can flow into the servo area. However, since the flow direction of a resist is orthogonal between the data area and the servo area, conductance of a resist between the data area and the servo area is low. Therefore only a residual resist in the servo area enjoys the smaller inhibition and resistance in flow paths of a servo area and the flow of a residual resist in the data area is inhibited to the degree harder than the flow of a residual resist in the servo area. These result in a thicker residual film being formed in the data area than in the servo area.

The present inventors analyzed resist flow according to a concavo-convex pattern of a mold, and found that dead ends are produced at at least one of the innermost circumferential edge and the outermost circumferential edge of a concavo-convex pattern in the servo area extending in radial directions and that these dead ends influence the above mentioned thickness of the residual film and the flowability of the resist.

Therefore, improvement strategies by which the above mentioned problems are solved include first of all a strategy to extend at least one of the outermost circumferential edge and the innermost circumferential edge of a concavo-convex pattern in a servo area and not to produce dead ends. In such a strategy it is important not only to make openings but also to control conductance of flow paths of a resist. When the sizes of opening and the conductance of flow paths of a resist are excessively large, mainly a resist in servo areas flows, and especially in a servo area with an irregular pattern of a sparse part and a dense part a resist flows into the sparse part in a concentrated manner, which is not preferable. When the sizes of opening and the conductance of flow paths of a resist are excessively small, resist flow in servo areas is also inhibited, and a resist becomes difficult to flow into even the sparse part, which is also not preferable. Thus the present inventors found that by setting appropriate sizes of opening and conductance of flow paths of a resist, resist flow of servo areas and data areas is realized in a balanced manner.

The dimension in a radial direction of an area of dummy pattern formed is preferably in the range of 0.1 mm to 1.0 mm. When the dimension is less than 0.1 mm, the conductance becomes excessively small due to small sizes of opening, which lowers the flowability of a resist and generates an uneven residual film of a resist. When the dimension is more than 1.0 mm, the conductance becomes excessively large, which produces a thick residual film in data areas.

The opening means a space formed by concave portions in an extended servo area in the dummy pattern. Thus the opening is a pattern serving as flow paths for an ejected resist extending in a radial direction, not a mere opening provided for the sole purpose of preventing the imprint mold structure from having dead ends at the outermost circumference or the innermost circumference of a servo area. Therefore, the volume of the opening is represented by the product of the length in a radial direction of the dummy pattern in an outermost circumference or an innermost circumference of a servo area and the cross-sectional area of all the concave portions of the outermost circumference or the innermost circumference of the servo area.

Furthermore, the servo area 120 is more preferably formed such that the width in a circumferential direction is enlarged from the inner circumference toward the outer circumference with respect to the substantial center of the substrate 2.

Specifically, the servo area 120 satisfies the following mathematical expression: $Wa < Wb$, wherein in the servo area $Wa$ represents a first width in a circumferential direction closer to the inner circumference than a second width and $Wb$ represents the second width in a circumferential direction closer to the outer circumference than the first width.

Here, the width of a servo area 120 in the present invention is defined as the distance between two data areas 110 in a given circumferential direction formed so as to sandwich the servo area 120. The distance is measured with respect to the convex portions or the concave portions (of the data areas) which directly sandwich the servo area 120.

The shape of a vertical cross-section of a concavo-convex pattern 3 in a data area taken on a line that has a radial direction of the concentric circles (a direction perpendicular to the direction in which the convex portion extends) is for example rectangular.

The shape of a vertical cross-section of a concavo-convex pattern 3 in a data area taken on a line that has a radial direction of the concentric circles is not limited to rectangle, and can be selected from arbitrary shapes depending on the purpose by controlling an etching process described later.

Hereinafter in the description of the present embodiment, "(shape of) a cross-section" means, unless otherwise stated, the (shape of) a vertical cross-section of a concavo-convex pattern 3 in a data area taken on a line that has a radial direction of the concentric circles (a direction perpendicular to the direction in which the convex portion extends).

- Other member -

An additional member is not particularly limited and can be appropriately selected depending on the purpose, as long as it does not impair the effects of the present invention; and an example thereof includes a mold surface layer which is formed on the substrate 2 in layer and provides separability from the imprint resist layer.

«Imprint resist layer»

The imprint resist layer is a layer formed by coating a substrate of a magnetic recording medium with an imprint resist composition (hereinafter, otherwise referred to as an "imprint resist solution").

The imprint resist layer 25 is not particularly limited, can be appropriately selected from those known in the art depending on the purpose, and is a layer formed by coating a substrate 40 of a magnetic recording medium with an imprint resist composition (hereinafter, otherwise referred to as an "imprint resist solution") containing, for example, at least any one of a thermoplastic resin and a photocurable resin.

For the imprint resist composition forming the imprint resist layer 25, for example, novolac resins, epoxy resins, acrylic resins, organic glass resins and inorganic glass resins are used.

The thickness of the imprint resist layer 25 is preferably 5% to less than 200% of the height of convex portions formed on the surface 2a on a mold 1. When the height is less than 5%, the amount of a resist is insufficient and a desired resist pattern can not be formed.

The thickness of an imprint resist layer can be measured, for example, by separating a part of the resist from the substrate coated with the resist and by measuring the height of a step obtained after the separating with an AFM (DIMENSION5000, manufactured by Veeco Instruments).

[Viscosity of imprint resist composition]

The viscosity of the imprint resist composition is measured, for example, with an ultrasonic viscosity meter.
An imprint mold structure of the present invention preferably satisfies the following Mathematical Expression 1:

$$0.001 \leq P/NW < 0.45 \qquad \text{Mathematical Expression 1}$$

wherein P (mPa·s) represents the viscosity of the imprint resist composition, N represents the number of convex portions or concave portions 4 of the servo areas, and W represents the ratio of the width of the concavo-convex pattern in a servo area along the outermost circumference (WO) to the width of the concavo-convex pattern in the servo area along the innermost circumference (WI) (W = WO/WI), and wherein $0.5 \leq P \leq 70$.
W is preferably in the range of 1.5 to 2.8, and the number (N) of concavo-convex portions 4 of the servo areas is preferably in the range of 60 to 300. The number (N) of concavo-convex portions 4 of the servo areas is counted with comparator equipment (MM-800, manufactured by NIKON CORPORATION).
Furthermore, the width WI of a concavo-convex pattern in a servo area along the innermost circumference and the width WO of a concavo-convex pattern in the servo area along the outermost circumference are measured, for example, with comparator equipment (MM-800, manufactured by NIKON CORPORATION).

<Method for manufacturing imprint mold structure>

Hereinafter, an example of a method for manufacturing an imprint mold structure according to the present invention will be described, with reference to the drawings. The imprint mold structure according to the present invention may be an imprint mold structure manufactured by a method for manufacuturing an imprint mold structure other than the method described below.

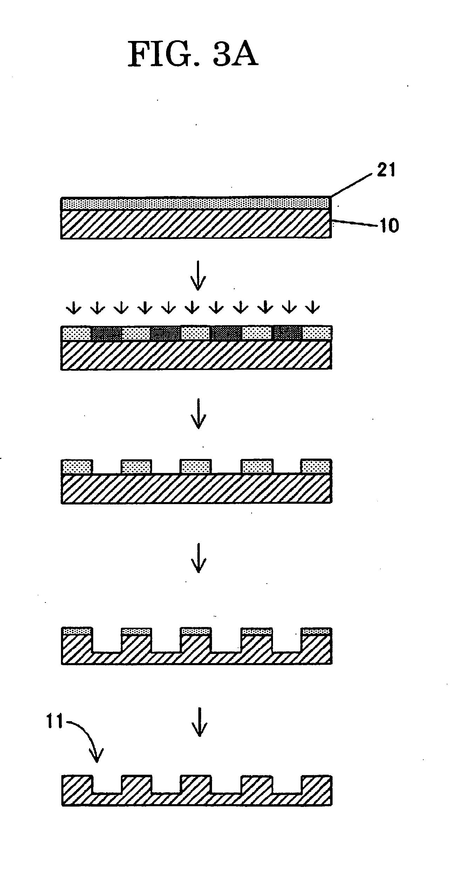

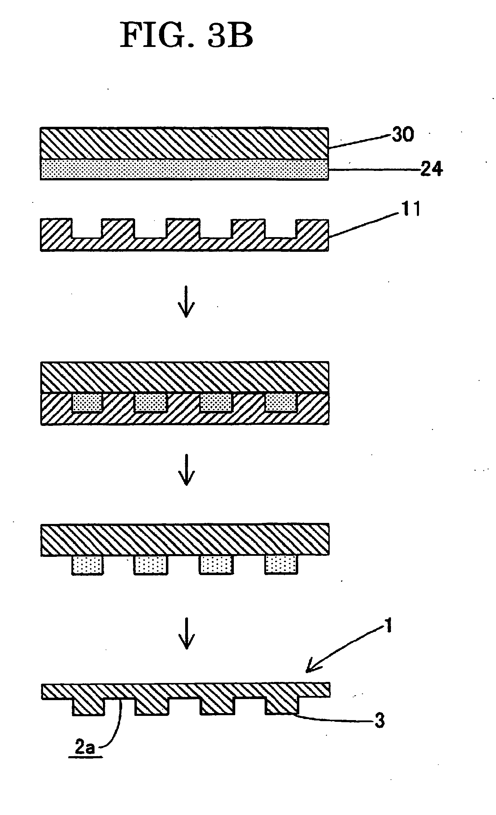

FIGS. 3A and 3B are cross-sectional views exemplarily showing a method for manufacuturing a mold structure 1. First, as shown in FIG. 3A, a photoresist solution, such as a novolac resin or an acrylic resin solution is applied onto an Si base 10 by spin coating or the like to form a photoresist layer 21.
Then the Si base 10 is irradiated with a laser beam (or an electron beam) that is modulated according to a servo signal with the Si base 10 rotating to expose a predetermined pattern at a corresponding part of each frame on tracks over the entire photoresist surface. The predetermined pattern is, for example, a pattern corresponding to a servo signal that extends linearly in a radial direction from the rotational center to each track.
Subsequently, the photoresist layer 21 is developed to remove those portions exposed, the pattern of the photoresist layer 21 from which those portions have been removed is used as a mask and the Si base 10 is selectively etched by RIE or the like to thereby obtain an master plate 11 having a convexo-concave pattern.
For the method for manufacturing a mold by using the master plate 11, a plating method, a nanoimprint method and the like may be used.
The method for manufacturing a mold by a plating method is described below.
First, a conductive layer (not shown) is formed on the surface of the master plate 11. For a method for forming the conductive film, a vacuum film-forming method (such as sputtering and vapor deposition), a nonelectrolytic plating method or the like may be generally used.
For a material used for the conductive layer, a metal or an alloy containing at least one selected from Ni, Cr, W, Ta, Fe and Co may be used. Ni, Co and an alloy of FeCo are preferable. A nonmetal material having conductive property, such as TiO, may also be used as a conductive layer.
The thickness of the conductive layer is preferably in the range of 5 nm to 30 nm, more preferably in the range of 10 nm to 25 nm.
Onto the master plate with the conductive layer formed on the surface thereof, a metal material or an alloy material is deposited by plating until a plated base has a predetermined thickness, and then the plated base is separated from the master plate 11, thereby forming the mold.
For the plating material constituting the mold, Ni, Cr, an alloy of FeCo or the like may be used, and a Ni material is preferably used.
The thickness of the mold 1 after it has been separated from the master plate is preferably in the range of 30 $\mu$m to 500 $\mu$m, and more preferably in the range of 45 $\mu$m to 300 $\mu$m. When the thickness is less than 30 $\mu$m, the rigidity of the mold is reduced, and sufficient mechanical property cannot be secured.
In addition, use of the mold 1 multiple times in the transfer step (NIL, nanoimprint lithography) makes the mold 1 itself deform, resulting in a significant degradation of properties in practical use. When the thickness of the mold is 500 μm or more, the rigidity of the mold becomes too high to secure tight adhesion between the mold 1 and a substrate 40 of a magnetic recording medium at the time of NIL (nanoimprint lithography).

In order to secure the tight adhesion, an adhesion pressure therebetween needs to be increased, and thus a fatal pattern defect may occur between the mold 1 and the substrate 40 of the magnetic recording medium when a foreign object is incorporated thereinto.

A duplicate of mold 1 may be produced by using the above mentioned mold as the master plate 11.

The method for producing a duplicate of the mold by a nanoimprint method is described below.

As shown in FIG. 3B, an imprint resist solution containing a thermoplastic resin or a photocurable resin is applied onto one surface of a substrate 30 to form an imprint resist layer 24, and then the master plate 11 is pressed against the imprint resist layer to transfer the convex portion pattern formed on the surface of the master plate 11 to the imprint resist layer 24.

Here, predetermined regions of an imprint resist layer 24 corresponding to at least one of the inner circumferential edge and the outer circumferential edge of a magnetic recording medium may be removed, after the imprint resist layer 24 is formed on the substrate 30. The predetermined regions are preferably regions corresponding to regions of a magnetic recording medium within 1mm from the inner circumferential edge or the outer circumferential edge. The flowability of the imprint resist 24 can be increased by overlap of the removed regions and the dummy patterns of mold 1.

A material for the substrate 30 is not particularly limited, can be appropriately selected depending on the purpose, as long as it has optical transparency and has a strength to serve as a mold structure 1, and examples thereof include quartz ($SiO_2$) and organic resins (PET, PEN, polycarbonate and fluorine resins having low glass transition temperatures).

The description "a material has optical transparency" specifically means that when a light beam is incident from a certain surface of the substrate 30 such that the light beam exits from the other surface of the substrate 30 on which the imprint resist layer 24 has been formed, the imprint resist solution is sufficiently cured, and means that the light transmittance of light beam having a wavelength of 400 nm or less emitted from the certain surface to the other surface of the substrate is 50% or more.

Further, the description "a material has a strength to serve as a mold structure" means that the material has such a strength that it is separable and can bear stress without being damaged when a mold structure is pressed against an imprint resist layer 24 formed on a magnetic recording medium substrate 30 under the condition of an average surface pressure of 1 kgf/cm$^2$ or more and the imprint resist layer is pressurized.

- Curing step -

Then, the transferred pattern is cured by cooling or applying ultraviolet ray to the imprint resist layer 24. When the pattern is cured by exposure to ultraviolet radiation, it may be exposed to ultraviolet radiation for curing after the mold structure is separated from the magnetic recording medium after patterning.

- Pattern forming step -

Subsequently, the substrate is selectively etched by RIE or the like while using the transferred pattern as a mask, thereby obtaining a mold structure 1 having a convexo-concave pattern. Furthermore, an inorganic material may be formed on the surface of the substrate to form a mask of the inorganic material based on the resist mask, and the substrate may be etched using this inorganic material mask to form the mold structure 1.

(Magnetic recording medium)

The following is a description of a magnetic recording medium prepared by using an imprint mold structure according to the present invention, such as a discrete track medium and a patterned medium, with reference to the drawings. Note that the magnetic recording medium according to the present invention may be that prepared by other manufacturing method than the manufacturing method described below, as long as it is prepared by using the imprint mold structure according to the present invention.

As shown in FIG. 4, a mold structure 1 is pressed against a magnetic recording medium substrate 40 on which a magnetic layer 50 and an imprint resist layer 25 of an imprint resist solution are sequentially formed, such that a pattern of a concavo-convex pattern 3 in a data area and a pattern of a concavo-convex pattern 4 in a servo area 120 both formed on the mold structure 1 are transferred to the imprint resist layer 25.

As an imprint resist composition for the imprint resist layer 25 used in preparation of a magnetic recording medium, the same imprint resist composition as those used for the imprint resist layer 24 in preparation of an imprint mold structure may be employed.

Hereinafter, unless otherwise stated, an "imprint resist layer" and an "imprint resist composition" indicate an imprint resist layer 25 in preparation of a magnetic recording medium, and an imprint resist composition forming the imprint resist layer 25, respectively.

Subsequently, the magnetic layer is etched by using as a mask the imprint resist layer 25 on which a concavo-convex pattern 3 in the data area and a concavo-convex pattern 4 in the servo area 120 have been transferred, whereby the concavo-convex pattern corresponding to the concavo-convex pattern formed on the mold structure 1 is formed on the magnetic layer 50. Then, a nonmagnetic layer 70 is formed by embedding a nonmagnetic material into concave portions in the etched magnetic layer, the surface of the magnetic recording medium with magnetic portions and nonmagnetic portions is flattened, the other steps such as a protective film forming step is carried out as required, and a magnetic recording medium 100 is thereby obtained.

The etching step is a step in which concavo-convex portions corresponding to the resist concavo-convex pattern in a data area on the imprint resist layer 25 are formed on an area of the magnetic layer 50 corresponding to the data area.

As a method for forming the concavo-convex pattern, ion beam etching, reactive chemical etching, wet etching or the like may be used.

As a process gas in the ion beam etching Ar can be used, as an etchant in the reactive chemical etching, $CO + NH_3$ or chlorine gas may be used.

For other steps, for example, as required, a step of embedding nonmagnetic material such as $SiO_2$, carbon, alumina, polymer such as polymethylmethacrylate (PMMA) or polystyrene (PS), or a lubricant oil in concave portions of the magnetic layer, a step of smoothing the surface of the magnetic layer, a step of forming a protective film on the smoothed surface with DLC (diamond-like carbon) or the like, and a final step of applying a lubricant oil are exemplified.

The magnetic recording medium of the present invention prepared as above has, on a surface of the substrate thereof, a plurality of magnetic pattern portions of data areas formed concentrically at predetermined intervals and a plurality of magnetic pattern portions of servo areas formed in radial directions of the mold substrate at predetermined intervals with a nonmagnetic material separating the two groups of magnetic pattern portions. Although not shown, the magnetic recording medium substrate is a disc of the same size as the substrate 2 of the imprint mold structure and has a hole in the disc.

In such configuration, a plurality of servo areas are formed in radial directions in an equiangular manner so as to separate a plurality of data areas.

Furthermore, the servo area is more preferably formed such that the width in a circumferential direction is enlarged from an inner circumference toward an outer circumference with respect to the hole of a magnetic recording medium substrate.

Specifically, a servo area more preferably satisfies the following mathematical expression: Wc < Wd, wherein in the servo area Wc represents a first width in a circumferential direction closer to the inner circumference than a second width and Wd represents the second width in a circumferential direction closer to the outer circumference than the first width.

Here, the width of a servo area in the present invention is defined as the distance between a border line of meeting of the servo area and an adjacent data area at the same radius and another border line of meeting of the servo area and the other adjacent data area on the same radius, wherein the servo area and the data area are each defined as an area where there are magnetic pattern portions of the servo area and the data area, respectively.

Also the magnetic recording medium of the present invention preferably satisfies the following Mathematical Expression 1:

$$0.001 \leq P/NW < 0.45 \qquad \text{Mathematical Expression 1}$$

wherein P (mPa·s) represents the viscosity of the imprint resist composition, N represents the number of magnetic pattern portions of the servo areas, and W represents the ratio of the width of the magnetic pattern portion of a servo area along the outermost circumference (WO) to the width of the magnetic pattern portion of the servo area along the innermost circumference (WI) (W = WO/WI), and wherein $0.5 \leq P \leq 70$.

The W is more preferably in the range of 1.5 to 2.8, and the number (N) of magnetic pattern portions of the servo areas is more preferably in the range of 60 to 300.

Furthermore, the width WI of a magnetic pattern portion of the servo area along the innermost circumference and the width WO of a magnetic pattern portion of the servo area along the outermost circumference are measured, for example, with comparator equipment (MM-800, manufactured by NIKON CORPORATION).

EXAMPLES

Hereafter, Examples of the present invention will be described, however, the present invention is not limited to the following Examples in any way.

(Example 1)

<Preparation of imprint mold structure>

«Preparation of master plate»

An electron beam resist was applied onto a disc-shaped Si substrate of 20.32 cm (8 inch) in diameter by spin coating to form a layer of 100 nm in thickness.

Subsequently, the electron beam resist was exposed with a desired pattern by a rotary electron beam exposing apparatus, and then subjected to a developing process to form an electron beam resist having a concavo-convex pattern on a Si substrate.

The resist-coated Si substrate was subjected to reactive ion etching using as a mask the electron beam resist having a concavo-convex pattern to form a concavo-convex pattern on the Si substrate.

Thereafter, a residual electron beam resist was removed by washing with a solvent capable of dissolving it, and the Si substrate was dried to prepare a master plate.

Broadly, the concavo-convex patterns were divided into concavo-convex patterns in data areas and concavo-convex patterns in servo areas.

Data areas were formed of a concavo-convex pattern in which a convex portion is 120 nm in width and a concave portion is 30 nm in width (the track pitch is 150 nm).

A servo area had a basic signal length of 90 nm and a total sector number of 50 and was formed of a preamble portion (45 bit), an SAM portion (10 bit), a sector code portion (8 bit), a cylinder code portion (32 bit), and a burst portion.

The SAM portion employed the number "0000101011", a concavo-convex pattern in the sector code portion was formed using Binary conversion, and a concavo-convex pattern in the cylinder code portion was formed using Gray conversion.

A concavo-convex pattern in the burst portion employed a typical phase burst signal (16 bit) and was formed using Manchester conversion.

Subsequently, a novolac resist (Microresist company; mr-I7000E) was applied onto a quartz substrate by spin coating (at 3,600 rpm) to form a layer of 100 nm in thickness.

Then the quartz substrate with a novolac resist layer was subjected to nanoimprinting using the master plate as a mold.

The quartz substrate was etched by RIE employing $CHF_3$ as an etchant using the resist concavo-convex pattern formed after the nanoimprinting, to obtain an imprint mold structure 1. Note that a releasing layer was formed by a wet method on the surface (the surface which is pressed against a resist layer on a magnetic recording medium) of the imprint mold structure 1 thus prepared. For a releasing agent constituting the releasing layer, EGC-1720 (manufactured by Sumitomo 3M Limited) was used.

A dummy pattern with the dimension indicated in Table 1 was provided in an area of the mold structure 1 corresponding to the area on a magnetic recording medium substrate which extends internally from the innermost circumferential edge of a pattern forming area.

«Measurement of width of concavo-convex pattern in servo area»

For the imprint mold structure thus prepared, WO and WI, widths of the concavo-convex pattern in a servo area, were measured. The results are shown in Table 1.

«Number of convex portions or concave portions of servo areas»

For the imprint mold structure thus prepared, the number of convex portions or concave portions of the servo areas was counted with comparator equipment (MM-800, manufactured by NIKON CORPORATION). The result is shown in Table 1.

<Preparation of magnetic recording medium>

Layers were deposited over a 6.35 cm (2.5-inch) glass substrate in the following manner to prepare a magnetic recording medium. In the magnetic recording medium thus prepared, a soft magnetic layer, a first nonmagnetic orientation layer, a second nonmagnetic orientation layer, a magnetic layer (otherwise referred to as a magnetic recording layer), a protective layer, and a lubricant layer were sequentially formed.

The soft magnetic layer, first nonmagnetic orientation layer, second nonmagnetic orientation layer, magnetic recording layer, and protective layer were formed by sputtering, and the lubricant layer was formed by a Dip method.

<Formation of soft magnetic layer>

As the soft magnetic layer, a layer of 100 nm in thickness composed of CoZrNb was formed.
Specifically, the glass substrate was set facing the CoZrNb target, then Ar gas was injected such that its pressure became 0.6 Pa, and the soft magnetic layer was formed at 1,500 W (DC).

<Formation of first nonmagnetic orientation layer>

As the first nonmagnetic orientation layer, a Ti layer of 5 nm in thickness was formed.
Specifically, the soft magnetic layer over the glass substrate was set facing the Ti target, then Ar gas was injected such that its pressure became 0.5 Pa, and as the first nonmagnetic orientation layer the Ti seed layer was formed at 1,000 W (DC) to form a layer of 5 nm in thickness.

<Formation of second nonmagnetic orientation layer>

Subsequently, as the second nonmagnetic orientation layer, a Ru layer of 10 nm in thickness was formed.
The first nonmagnetic orientation layer formed over the substrate was set facing the Ru target, then Ar gas was injected such that its pressure became 0.5 Pa, and as the second nonmagnetic orientation layer a Ru layer was formed at 1,000 W (DC) to form a layer of 10 nm in thickness.

<Formation of magnetic recording layer>

Then, as the magnetic recording layer, a CoCrPtO layer of 15 nm in thickness was formed.
Specifically, the second nonmagnetic orientation layer formed over the substrate was set facing the CoPtCr target, then Ar gas containing 0.04% $O_2$ was injected such that its pressure became 18 Pa, and the magnetic recording layer was formed at 290 W (DC).

<Formation of protective layer>

After the formation of the magnetic recording layer, the magnetic recording layer formed over the substrate was set facing a C target, then Ar gas was injected such that its pressure became 0.5 Pa, the C protective layer of 4 nm in thickness was formed at 1,000 W (DC).
The coercive force of the magnetic recording medium thus obtained was 334 kA/m (4.2 kOe).
The primary nonmagnetic material of a magnetic recording medium of this Example is, for example, PtO.

<Formation of imprint resist layer>

As an imprint resist composition, an acrylic resist (PAK-01-500, manufactured by Toyo Gosei Co., Ltd.) was applied onto the thus prepared protective layer by spin coating (at 3,600 rpm) to form an imprint resist layer of 100 nm in thickness.

«Viscosity of imprint resist composition»

The viscosity of the imprint resist composition was measured using an ultrasonic viscosity meter. The result is shown in Table 1.

<Calculation of P/NW>

The value of P/NW was calculated from the above results. The result is shown in Table 1.

<Transfer step>

The surface of the above mold onto which a concavo-convex pattern had been formed was set facing a substrate covered by an imprint resist layer to attach the substrate covered by the imprint resist layer under a pressure of 3 MPa for 10 sec to the surface. The substrate covered by the imprint resist layer was exposed to UV at a dose of 10 mJ/cm$^2$.
After the completion of the above steps, the mold was separated from the substrate onto which the imprint resist layer had been formed.
Subsequently, a residual imprint resist layer in concave portions of the substrate was removed by O$_2$ reactive chemical etching, where the concave portions were in the concavo-convex patterns in the imprint resist layer formed by transferring a concavo-convex pattern corresponding to the concavo-convex patterns of the mold onto the imprint resist layer. The O$_2$ reactive chemical etching was carried out so that the magnetic layer was exposed in the concave portions.

<Magnetic pattern portion forming step>

After the residual imprint resist layer in the concave portions had been removed, a concavo-convex pattern was formed on the magnetic layer.
For forming a concavo-convex pattern on the magnetic layer, ion beam etching was employed.
Specifically, Ar gas was used with an ion accelerating energy of 500 eV and with an incident angle of the ion beam being perpendicular to the magnetic layer.
After a concavo-convex pattern had been thus formed on the magnetic layer, a residual resist on the magnetic layer was removed by O$_2$ reactive chemical etching.
Subsequently, a PFPE lubricant was applied onto the magnetic recording medium substrate with the magnetic layer having a concavo-convex pattern to form a layer of 2 nm in thickness by a Dip method.

<Nonmagnetic pattern portion forming step>

After a concavo-convex pattern was formed on the magnetic layer, a SiO$_2$ layer was formed in the concavo-convex pattern by sputtering so that a complex layer of the SiO$_2$ layer and the magnetic material layer had a thickness of 50 nm. Subsequently the complex layer of the SiO$_2$ layer and the magnetic material layer was subjected to ion beam etching to remove redundant SiO2 layer such that the height of the magnetic pattern portions became equal to that of the nonmagnetic pattern portions and that both portions had a common flat surface.

«Evaluation of formability of resist pattern»

The resist patterns were compared between data areas and servo areas of the substrates in which the surface corresponding to servo areas had not been coated, and NIL uniformity was evaluated as follows.
First, each of intermediate products of perpendicular magnetic recording media on which a resist pattern had been formed via a transfer step, were fractured, and then the film thickness of a resist residue remaining in the data areas and the height of resist patterns in burst areas in the servo areas were measured in cross-sections of the fractions using a scanning electron microscope (FE-SEM S800 manufactured by Hitachi, Ltd.). When the ratio of the height of the resist pattern in the burst area of the servo area and the height of the resist pattern in the data area was in the range of 0.95 to 1.0, the formability of resist pattern was evaluated as "A"; when the ratio was in the range of 0.90 to less than 0.95 the resist pattern formability was evaluated as "B", when the ratio was in the range of 0.85 to less than 0.90 the resist pattern formability was evaluated as "C", and when the ratio was in the range less than 0.85 the resist pattern formability was evaluated as "D".
The thicknesses of the resist samples were measured at eight sites per disc within an area having a radius of 20 mm at substantially equiangular spacing, and the average of the eight ratios was calculated to thereby evaluate the (average) resist pattern formability.

<Evaluation of magnetic recording medium>

«Evaluation of signal integrity of servo signal»

On the prepared perpendicular magnetic recording media in which each of the magnetic layers had been formed, reproduction output powers of TAA (Track Average Amplitude) of a preamble area and a burst area were detected for all the sectors. For an evaluation apparatus, LS-90 (manufactured by Kyodo Denshi, K.K.) was used. A GMR head having a read width of 120 nm and a write width of 200 nm was mounted to the apparatus.
In each of the perpendicular magnetic recording media, points were measured for reproduction output powers of TAA at 1 mm intervals in a radial direction from a radius of 20 mm to a radius of 32 mm of the recording medium to calculate the average reproduction output power for the preamble area and the burst area. When the ratio of the average output power of the burst areas to the average output power of the preamble areas was in the range of 0.8 to 1.0, the signal integrity of servo signals was evaluated as "A"; when the ratio was in the range of 0.6 to less than 0.8, the signal integrity of servo signals was evaluated as "B"; and when the ratio was in the range less than 0.6, the signal integrity of servo signals was evaluated as "C". Note that the servo signals evaluated as "A" and "B" are usable.

In addition, uniformity of the signals was evaluated. A standard deviation ($\sigma$) of the ratios of the output power of the preamble area and that of the ratios of the output power of the burst area were calculated to introduce a $3\sigma$ value. When an absolute value of [$3\sigma$ value]/[average value] was less than 0.05, the uniformity of the output power of the signals was evaluated as "A", when the absolute value was in the range of 0.05 to less than 0.1, the uniformity of the output power of the signals was evaluated as "B", and when the absolute value was in the range of 0.1 or more, the uniformity of the output power of the signals was evaluated as "C".

(Example 2)

<Preparation of imprint mold structure>

An imprint mold structure was prepared in the same manner as in Example 1, except that a concavo-convex pattern in a servo area was extended to an area of the imprint mold structure corresponding to the outermost circumferential edge of a pattern forming area of a magnetic recording medium.

Note that a dummy pattern with the dimension indicated in Table 1 was provided in an area of the imprint mold structure corresponding to the area on the magnetic recording medium substrate which extends externally from the outermost circumferential edge of the pattern forming area.

«Measurement of width of concavo-convex pattern in servo area»

For the imprint mold structure thus prepared, the width of a concavo-convex pattern in a servo area was measured in the same manner as in Example 1. The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used in place of the imprint mold structure prepared in Example 1.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 3)

<Preparation of imprint mold structure>

An imprint mold structure was prepared in the same manner as in Example 1, except that a concavo-convex pattern in a servo area reached the two edges corresponding to the two edges of the pattern forming area of a magnetic recording medium, that is the innermost circumferential edge and the outermost circumferential edge of a pattern forming area.

Note that the two dummy patterns with dimensions indicated in Table 1 were provided such that each corresponding dummy pattern of the magnetic recording medium extends from the innermost circumferential edge or from the outermost circumferential edge of the pattern forming area.

«Measurement of width of concavo-convex pattern in servo area»

For the imprint mold structure thus prepared, the width of a concavo-convex pattern in a servo area was measured in the same manner as in Example 1. The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used in place of the imprint mold structure prepared in Example 1.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 3 for the magnetic recording medium thus prepared. The result is shown in Table 1.

(Example 4)

<Preparation of imprint mold structure>

In this Example, an imprint mold structure was prepared in the same manner as in Example 3.

«Measurement of width of concavo-convex pattern in servo area»

For the imprint mold structure thus prepared, the width of a concavo-convex pattern in a servo area was measured in the same manner as in Example 1. The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1, except that an acrylic resist (PAK-01-60, manufactured by Toyo Gosei Co., Ltd.) was used in place of the imprint resist composition of Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint resist composition described in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 5)

<Preparation of imprint mold structure>

An imprint mold structure was prepared in the same manner as in Example 3.

«Measurement of width of concavo-convex pattern in servo area»

For the imprint mold structure thus prepared, the widths of a concavo-convex pattern in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1, except that an acrylic resist (PAK-01, manufactured by Toyo Gosei Co., Ltd.) diluted with acetone by twofold, was used in place of the imprint resist composition of Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 6)

<Preparation of imprint mold structure>

An imprint mold structure was prepared in the same manner as in Example 3, except that WO was changed as shown in Table 1.

«Measurement of width of concavo-convex pattern in servo area»

For the imprint mold structure thus prepared, the widths of a concavo-convex pattern in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 5.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 7)

<Preparation of imprint mold structure>

An imprint mold structure was prepared in the same manner as in Example 3, except that WO was changed as shown in Table 1.

«Measurement of width of concavo-convex pattern in servo area»

For the imprint mold structure thus prepared, the widths of a concavo-convex pattern in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 5.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 8)

<Preparation of imprint mold structure>

An imprint mold structure was prepared in the same manner as in Example 3, except that WO was changed as shown in Table 1.

«Measurement of width of concavo-convex pattern in servo area»

For the imprint mold structure thus prepared, the widths of a concavo-convex pattern in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 5.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 9)

<Preparation of imprint mold structure>

An imprint mold structure was prepared in the same manner as in Example 8, except that N was changed as shown in Table 1.

«Measurement of width of concavo-convex pattern in servo area»

For the imprint mold structure thus prepared, the widths of a concavo-convex pattern in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 5.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 10)

<Preparation of imprint mold structure>

An imprint mold structure was prepared in the same manner as in Example 3.

«Measurement of width of concavo-convex pattern in servo area»

For the imprint mold structure thus prepared, the widths of a concavo-convex pattern in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1, except that an acrylic resist (PAK-01-60, manufactured by Toyo Gosei Co., Ltd.) diluted with acetone by 5/4 -fold, was used in place of the imprint resist composition of Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 11)

<Preparation of imprint mold structure>

An imprint mold structure was prepared in the same manner as in Example 3.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1, except that an acrylic resist (PAK-01, manufactured by Toyo Gosei Co., Ltd.) was used in place of the imprint resist composition of Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared for this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 12)

<Preparation of imprint mold structure>

An imprint mold structure was prepared in the same manner as in Example 1, except that a dummy pattern with the dimension indicated in Table 1 was provided in an area of the imprint mold structure corresponding to the area on a magnetic recording medium substrate which extends internally from the innermost circumferential edge of the pattern forming area.

«Measurement of width of concavo-convex pattern of servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 13)

<Preparation of imprint mold structure>

An imprint mold structure was prepared in the same manner as in Example 2, except that a dummy pattern with the dimension indicated in Table 1 was provided in an area of the imprint mold structure corresponding to an area on a magnetic recording medium substrate extending externally from the outermost circumferential edge of the pattern forming area.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 14)

<Preparation of imprint mold structure>

An imprint mold structure was prepared in the same manner as in Example 1, except that a dummy pattern with the dimension indicated in Table 1 was provided in an area of the imprint mold structure corresponding to the area on a magnetic recording medium substrate which extends internally from the innermost circumferential edge of the pattern forming area.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 15)

<Preparation of imprint mold structure>

An imprint mold structure was prepared in the same manner as in Example 2, except that a dummy pattern with the dimension indicated in Table 1 was provided in an area of the imprint mold structure corresponding to the area on a magnetic recording medium substrate which extends externally from the outermost circumferential edge of the pattern forming area.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 16)

<Preparation of imprint mold structure>

An imprint mold structure was prepared in the same manner as in Example 3, except that the dimension of a dummy pattern of the imprint mold structure corresponding to the dummy pattern of a magnetic recording medium which extends externally from the outermost circumferential edge of a pattern forming area, was changed as shown in Table 1.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Example 17)

<Preparation of imprint mold structure>

An imprint mold structure was prepared in the same manner as in Example 3, except that the dimension of a dummy pattern of the imprint mold structure corresponding to the dummy pattern of a magnetic recording medium substrate which extends internally from the innermost circumferential edge of a pattern forming area, was changed as shown in Table 1.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Comparative Example 1)

<Preparation of imprint mold structure>

An imprint mold structure was prepared in the same manner as in Example 8, except that no dummy pattern was provided in the imprint mold structure of this Comparative Example.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Example 8.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Comparative Example 2)

<Preparation of imprint mold structure>

An imprint mold structure was prepared in the same manner as in Comparative Example 1.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Comparative Example 1, except that an acrylic resist (PAK-01-60, manufactured by Toyo Gosei Co., Ltd.) diluted with acetone by 5/4-fold, was used in place of the imprint resist composition of Comparative Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared in this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

(Comparative Example 3)

<Preparation of imprint mold structure>

An imprint mold structure was prepared in the same manner as in Comparative Example 1.

«Measurement of width of concavo-convex pattern in servo area»

For the imprint mold structure thus prepared, the widths of concavo-convex patterns in a servo area (WO and WI) were measured in the same manner as in Example 1 to calculate the ratio thereof (WO/WI). The results are shown in Table 1.

«Number of convex portions or concave portions of servo area»

For the imprint mold structure thus prepared, the number of convex portions or concave portions of the servo areas was counted in the same manner as in Example 1. The result is shown in Table 1.

<Formation of imprint resist layer>

An imprint resist layer was provided in the same manner as in Comparative Example 1, except that an acrylic resist (PAK-01, manufactured by Toyo Gosei Co., Ltd.) was used in place of the imprint resist composition of Comparative Example 1.

«Viscosity of imprint resist composition»

The viscosity of the imprint resist composition was measured in the same manner as in Example 1. The result is shown in Table 1.

<Preparation of magnetic recording medium>

A magnetic recording medium was prepared in the same manner as in Example 1, except that the imprint mold structure prepared for this Example was used.

<Calculation of P/NW>

The value of P/NW was calculated from the above results. The result is shown in Table 1.

«Evaluation of formability of resist pattern»

The formability of a resist pattern was evaluated in the same manner as in Example 1 in the preparation of the magnetic recording medium. The result is shown in Table 1.

<Evaluation of magnetic recording medium>

The signal integrity of servo signals was evaluated in the same manner as in Example 1 for the magnetic recording medium thus prepared. The result is shown in Table 1.

Table 1.

| | Dimension of dummy pattern of innermost circumferential edge (mm) | Dimension of dummy pattern of outermost circumferential edge (mm) | WO (nm) | WI (nm) | WO/WI | N | P | P/NW | Formability of resist pattern | Evaluation | Servo property (output) | Evaluation | Servo property (uniformity) | Evaluation |
|---|---|---|---|---|---|---|---|---|---|---|---|---|---|---|
| Ex.1 | 0.25 | 0 | 0.14 | 0.14 | 1.00 | 60 | 2 | 0.0400 | 0.86 | C | 0.79 | B | 0.06 | B |
| Ex.2 | 0 | 0.25 | 0.14 | 0.14 | 1.00 | 50 | 2 | 0.0400 | 0.87 | C | 0.77 | B | 0.07 | B |
| Ex.3 | 0.25 | 0.25 | 0.14 | 0.14 | 1.00 | 50 | 2 | 0.0400 | 0.91 | B | 0.79 | B | 0.04 | A |
| Ex.4 | 0.25 | 0.25 | 0.14 | 0.14 | 1.00 | 50 | 0.5 | 0.0100 | 0.93 | B | 0.85 | A | 0.03 | A |
| Ex.5 | 0.25 | 0.26 | 0.14 | 0.14 | 1.00 | 50 | 10 | 0.2000 | 0.94 | B | 0.81 | A | 0.04 | A |
| Ex.6 | 0.25 | 0.25 | 0.2 | 0.14 | 1.43 | 60 | 10 | 0.1400 | 0.92 | B | 0.85 | A | 0.03 | A |
| Ex.7 | 0.26 | 0.25 | 0.4 | 0.14 | 2.86 | 50 | 10 | 0.0700 | 0.94 | B | 0.84 | A | 0.02 | A |
| Ex.8 | 0.25 | 0.25 | 0.28 | 0.14 | 2.00 | 50 | 10 | 0.1000 | 0.97 | A | 0.92 | A | 0.02 | A |
| Ex.9 | 0.25 | 0.25 | 0.28 | 0.14 | 2.00 | 240 | 10 | 0.0208 | 0.98 | A | 0.94 | A | 0.01 | A |
| Ex.10 | 0.25 | 0.25 | 0.14 | 0.14 | 1.00 | 50 | 0.4 | 0.0080 | 0.93 | B | 0.85 | A | 0.04 | A |
| Ex.11 | 0.25 | 0.25 | 0.14 | 0.14 | 1.00 | 60 | 20 | 0.4000 | 0.89 | C | 0.76 | B | 0.04 | A |
| Ex.12 | 0.09 | 0 | 0.14 | 0.14 | 1.00 | 50 | 2 | 0.0400 | 0.85 | C | 0.69 | B | 0.06 | B |
| Ex.13 | 0 | 0.09 | 0.14 | 0.14 | 1.00 | 60 | 2 | 0.0400 | 0.86 | C | 0.7 | B | 0.08 | B |
| Ex.14 | 1.1 | 0 | 0.14 | 0.14 | 1.00 | 60 | 2 | 0.0400 | 0.87 | C | 0.79 | B | 0.04 | A |
| Ex.16 | 0 | 1.1 | 0.14 | 0.14 | 1.00 | 50 | 2 | 0.0400 | 0.88 | C | 0.71 | B | 0.03 | A |
| Ex.16 | 0.25 | 0.75 | 0.14 | 0.14 | 1.00 | 50 | 2 | 0.0400 | 0.96 | A | 0.91 | A | 0.02 | A |
| Ex.17 | 0.75 | 0.25 | 0.14 | 0.14 | 1.00 | 50 | 2 | 0.0400 | 0.97 | A | 0.89 | A | 0.02 | A |
| Comp. Ex.1 | 0 | 0 | 0.28 | 0.14 | 2.00 | 50 | 10 | 0.1000 | 0.76 | D | 0.59 | C | 0.15 | C |
| Comp. Ex.2 | 0 | 0 | 0.28 | 0.14 | 2.00 | 50 | 0.4 | 0.0040 | 0.81 | D | 0.58 | C | 0.12 | C |
| Comp. Ex.3 | 0 | 0 | 0.28 | 0.14 | 2.00 | 50 | 20 | 0.2000 | 0.75 | D | 0.56 | C | 0.19 | C |

As shown in Table 1, Examples 1 to 17, in which at at least any one of an inner circumferential edge and an outer circumferential edge of concavo-convex pattern in a data area or a servo area with respect to the center of a disc-shaped substrate of the imprint mold structure a dummy pattern is formed which corresponds to the pattern on a magnetic recording medium substrate which extends radially from at least any one of an inner circumferential edge and an outer circumferential edge of a pattern forming area, could provide an imprint mold structure with higher transferability than Comparative Examples 1 to 3 could, in which no dummy pattern had been formed for their imprint mold structures.

A magnetic recording medium excellent in recording and reproducing property could be provided by using an imprint mold structure prepared in each of Examples 1 to 17, in which at at least one of an inner circumferential edge and an outer circumferential edge of concavo-convex pattern of a data area or a servo area with respect to the center of a disc-shaped substrate of the imprint mold structure a dummy pattern is formed which corresponds to a pattern on a magnetic recording medium substrate extending radially from at least one of an inner circumferential edge and an outer circumferential edge of a pattern forming area.

Particularly, Example 8 in which the ratio of the width of the outermost circumference (WO) to the width of the innermost circumference (WI) was in the range of 1.5 to 2.8, and Example 9 in which the ratio of the width of the outermost circumference (WO) to the width of the innermost circumference (WI) was in the range of 1.5 to 2.8 and in which the number of convex portions or concave portions of the servo areas (N) was in the range of 60 to 300, could provide imprint mold structures and magnetic recording media which were excellent in formability of resist patterns.

## Claims

1. An imprint mold structure comprising:

a disc-shaped substrate having on a surface thereof concavo-convex patterns in a data area and in a servo area,
wherein the concavo-convex pattern in the data area is formed by forming a plurality of convex portions along concentric circumferences on the surface of the disc-shaped substrate, and
the concavo-convex pattern in the servo area is formed by radially forming ridges of a plurality of convex portions on the surface of the disc-shaped substrate,
wherein the imprint mold structure is configured for transferring the concavo-convex pattern onto an imprint resist layer, which is composed of an imprint resist composition formed on a disc-shaped magnetic recording medium substrate, by pressing the concavo-convex patterns in the data area and in the servo area against the imprint resist layer, and
wherein a dummy pattern is formed at an inner circumferential edge and/or an outer circumferential edge of the concavo-convex pattern in the servo area relative to the center of the disc-shaped substrate of the imprint mold structure, the dummy pattern extending radially from an inner circumferential edge and/or an outer circumferential edge of a pattern forming area on the magnetic recording medium substrate,
wherein the dimension of regions of the dummy pattern in a radial direction on the imprint mold structure is in the range of 0.1 mm to 1.0 mm.

2. The imprint mold structure according to claim 1,
wherein the width of the concavo-convex pattern in the servo area along the outermost circumference (WO) is larger than the width of the concavo-convex pattern in the servo area along the innermost circumference (WI).

3. The imprint mold structure according to any one of claims 1 or 2,
wherein the ratio of the width of the concavo-convex pattern in the servo area along the outermost circumference (WO) to the width of the concavo-convex pattern in the servo area along the innermost circumference (WI) (W:W = WO/WI) is in the range of 1.5 to 2.8.

4. The imprint mold structure according to any one of claims 1 to 3,
wherein the number (N) of convex portions or concave portions of the servo area is in the range of 60 to 300.

5. An imprinting method comprising:

Transferring a concavo-convex pattern onto an imprint resist layer formed on a magnetic recording medium substrate, by pressing the imprint mold structure according to any one of claims 1 to 4 against the imprint resist layer.

6. The imprinting method according to claim 5,

wherein conditions for the imprinting method satisfy the following Mathematical Expression 1:

$$0.001 \leq P/NW < 0.45 \qquad \text{Mathematical Expresssion 1}$$

wherein P represents the viscosity of the imprint resist composition in mPa·s, W represents the ratio of the width of the concavo-convex pattern in the servo area along the outermost circumference (WO) to the width of the concavo-convex pattern in the servo area along the innnermost circumference (WI) (W = WO/WI), and N represents the number of convex portions or concave portions of the servo area.

7. The imprinting method according to any one of claims 5 and 6,
   wherein the width of the concavo-convex pattern in the servo area along the outermost circumference (WO) is larger than the width of the concavo-convex pattern in the servo area along the innermost circumference (WI).

8. The imprinting method according to any one of claims 5 to 7,
   wherein the ratio of the width of the concavo-convex pattern in the servo area along the outermost circumference (WO) to the width of the concavo-convex pattern in the servo area along the innermost circumference (WI) (W:W = WO/WI) is in the range of 1.5 to 2.8.

9. The imprinting method according to any one of claims 5 to 8,
   wherein the number (N) of convex portions or concave portions of the servo area is in the range of 60 to 300.

10. A method for manufacturing a magnetic recording medium which comprises
    transferring a concavo-convex pattern onto an imprint resist layer formed on a magnetic recording medium substrate, by pressing an imprint mold structure according to any one of claims 1 to 4 against the imprint resist layer,
    forming on a first area of a magnetic layer a magnetic pattern portion of a data area corresponding to the concavo-convex pattern in a data area formed on the imprint mold structure and forming on a second area of the magnetic layer a magnetic pattern portion of a servo area formed on the imprint mold structure by etching the first and second area of the magnetic layer formed on a surface of the magnetic recording medium substrate using as a mask the imprint resist layer onto which a concavo-convex pattern have been transferred, and
    forming a nonmagnetic pattern portion by embedding a nonmagnetic material in a concave portion formed on the magnetic layer, and
    wherein the width of the magnetic pattern portion of the servo area along the outermost circumference (WO) is larger than the width of the magnetic pattern portion of the servo area along the innermost circumference (WI).

11. The method for manufacturing a magnetic recording medium according to claim 10,
    wherein the ratio of the width of the magnetic pattern portion of the servo area along the outermost circumference (WO) to the width of the magnetic pattern portion of the servo area along the innermost circumference (WI) (W:W = WO/WI) is in the range of 1.5 to 2.8.

12. The method for manufacturing a magnetic recording medium according to any one of claims 10 and 11,
    wherein the number of magnetic pattern portions of the servo area (N) is in the range of 60 to 300.

13. The method for manufacturing a magnetic recording medium according to any one of claims 10 to 12,
    wherein the magnetic pattern portions of the servo area are servo pattern.

14. The method for manufacturing a magnetic recording medium according to any one of claims 10 to 13,
    wherein the magnetic recording medium satisfies the following Mathematical Expression 1:

$$0.001 \leq P/NW < 0.45 \qquad \text{Mathematical Expresssion 1}$$

wherein P is in mPa·s and represents the viscosity of the imprint resist composition, W represents the ratio of the width of the magnetic pattern portion of the servo area along the outermost circumference (WO) to the width of the magnetic pattern portion of the servo area along the innermost circumference (WI) (W = WO/WI), and N represents the number of the magnetic pattern portions of the servo area.

**Patentansprüche**

1. Abdruckformstruktur umfassend:

   ein scheibenförmiges Substrat mit konkav-konvexen Mustern in einem Datenbereich und in einem Servobereich auf einer Oberfläche davon,
   wobei das konkav-konvexe Muster in dem Datenbereich durch Formen einer Mehrzahl von konvexen Abschnitten entlang konzentrischer Umfänge auf der Oberfläche des scheibenförmigen Substrats gebildet wird, und das konkav-konvexe Muster in dem Servobereich durch radiales Formen von Keilen einer Mehrzahl von konvexen Abschnitten auf der Oberfläche des scheibenförmigen Substrats gebildet wird,
   wobei die Abformstruktur zum Übertragen des konkav-konvexen Musters auf eine Abformlackschicht ausgestaltet ist, die aus einer Abformlackverbindung zusammengestellt ist, das auf einem scheibenförmigen Magnetaufnahmemediumssubstrat durch Drücken der konkav-konvexen Muster in dem Datenbereich und in dem Servobereich gegen die Abformlackschicht ausgebildet ist, und
   wobei ein Dummy-Muster an einer inneren Umfangskante und/oder einer äußeren Umfangskante des konkav-konvexen Musters in dem Servobereich in Bezug auf die Mitte des scheibenförmigen Substrats der Abformstruktur ausgebildet ist, wobei sich das Dummy-Muster radial von einer inneren umfangsseitigen Kante und/oder einer äußeren umfangsseitigen Kante eines ein Muster bildenden Bereichs auf dem Magnetaufnahmemediumssubstrat erstreckt,
   wobei die Dimension von Regionen des Dummy-Musters in einer radialen Richtung auf der Abformstruktur im Bereich von 0,1 mm bis 1,0 mm ist.

2. Abformstruktur nach Anspruch 1, wobei die Breite des konkav-konvexen Musters in dem Servobereich entlang dem äußersten Umfang (WO) größer als die Breite des konkav-konvexen Musters in dem Servobereich entlang dem innersten Umfang (WI) ist.

3. Abformstruktur nach einem der Ansprüche 1 oder 2,
   wobei das Verhältnis der Breite des konkav-konvexen Musters in dem Servobereich entlang dem äußersten Umfang (WO) zur Breite des konkav-konvexen Musters in dem Servobereich entlang dem innersten Umfang (WI) (W:W = WO/WI) in dem Bereich von 1,5 bis 2,8 ist.

4. Abformstruktur nach einem der Ansprüche 1 bis 3,
   wobei die Anzahl (N) konvexer Abschnitte oder konkaver Abschnitte des Servobereichs im Bereich von 60 bis 300 ist.

5. Abformverfahren umfassend:

   Übertragen eines konkav-konvexen Musters auf eine Abformlackschicht, das auf einem Magnetaufnahmemediumssubstrat durch Drücken der Abformstruktur nach einem der Ansprüche 1 bis 4 gegen die Abformlackschicht ausgebildet ist.

6. Abformverfahren nach Anspruch 5, wobei Bedingungen für das Abformverfahren den folgenden mathematischen Ausdruck 1 erfüllen:

$$0,001 \leq P/NW < 0,45 \qquad \text{Mathematischer Ausdruck 1}$$

   wobei P die Viskosität der Abformlackverbindung in mPa·s repräsentiert, W das Verhältnis der Breite des konkav-konvexen Musters in dem Servobereich entlang dem äußersten Umfang (WO) zur Breite des konkav-konvexen Musters in dem Servobereich entlang dem innersten Umfang (WI) (W = WO/WI) repräsentiert und N die Anzahl konvexer Abschnitte oder konkaver Abschnitte des Servobereichs repräsentiert.

7. Abformverfahren nach einem der Ansprüche 5 und 6,
   wobei die Breite des konkav-konvexen Musters in dem Servobereich entlang dem äußersten Umfang (WO) größer als die Breite des konkav-konvexen Musters in dem Servobereich entlang dem innersten Umfang (WI) ist.

8. Abformverfahren nach einem der Ansprüche 5 bis 7,
   wobei das Verhältnis der Breite des konkav-konvexen Musters in dem Servobereich entlang dem äußersten Umfang (WO) zu der Breite des konkav-konvexen Musters in dem Servobereich entlang dem innersten Umfang (WI) (W:W = WO/WI) im Bereich von 1,5 bis 2,8 ist.

9. Abformverfahren nach einem der Ansprüche 5 bis 8, wobei die Anzahl (N) konvexer Abschnitte oder konkaver Abschnitte des Servobereichs im Bereich von 60 bis 300 ist.

10. Verfahren zum Herstellen eines Magnetaufnahmemediums, welches umfasst Übertragen eines konkav-konvexen Musters auf eine Abformlackschicht durch Drücken einer Abformstruktur nach einem der Ansprüche 1 bis 4 gegen die Abformlackschicht, die auf einem Magnetaufnahmemediumssubstrat ausgebildet ist, Bilden eines Magnetmusterabschnitts eines Datenbereichs auf einem ersten Bereich einer Magnetschicht entsprechend dem konkav-konvexen Muster in einem Datenbereich, der auf der Abformstruktur ausgebildet ist, und Bilden eines Magnetmusterabschnitts eines Servobereichs auf einem zweiten Bereich der Magnetschicht, der auf der Abformstruktur ausgebildet ist, durch Ätzen des ersten und zweiten Bereichs der Magnetschicht, die auf einer Oberfläche des Magnetaufnahmemediumssubstrats ausgebildet ist, unter Verwendung der Abformlackschicht, auf die ein konkavkonvexes Muster übertragen worden ist, als eine Maske, und Bilden eines nicht-magnetischen Musterabschnitts durch Einbetten eines nicht-magnetischen Materials in einen konkaven Abschnitt, der auf der Magnetschicht ausgebildet ist, und wobei die Breite des Magnetmusterabschnitts des Servobereichs entlang dem äußersten Umfang (WO) größer als die Breite des Magnetmusterabschnitts des Servobereichs entlang dem innersten Umfang (WI) ist.

11. Verfahren zum Herstellen eines Magnetaufnahmemediums nach Anspruch 10, wobei das Verhältnis der Breite des Magnetmusterabschnitts des Servobereichs entlang dem äußersten Umfang (WO) zu der Breite des Magnetmusterabschnitts des Servobereichs entlang dem innersten Umfang (WI) (W:W = WO/WI) in dem Bereich von 1,5 bis 2,8 ist.

12. Verfahren zum Herstellen eines Magnetaufnahmemediums nach einem der Ansprüche 10 und 11, wobei die Anzahl von Magnetmusterabschnitten des Servobereichs (N) im Bereich von 60 bis 300 ist.

13. Verfahren zum Herstellen eines Magnetaufnahmemediums nach einem der Ansprüche 10 bis 12, wobei die Magnetmusterabschnitte des Servobereichs Servomuster sind.

14. Verfahren zum Herstellen eines Magnetaufnahmemediums nach einem der Ansprüche 10 bis 13, wobei das Magnetaufnahmemedium den folgenden mathematischen Ausdruck 1 erfüllt:

$$0{,}001 \leq P/NW < 0{,}45 \qquad \text{Mathematischer Ausdruck 1}$$

wobei P in mPa·s ist und die Viskosität der Abformlackverbindung repräsentiert, W das Verhältnis der Breite des Magnetmusterabschnitts des Servobereichs entlang dem äußersten Umfang (WO) zu der Breite des Magnetmusterabschnitts des Servobereichs entlang dem innersten Umfang (WI) (W = WO/WI) repräsentiert und N die Anzahl magnetischer Musterabschnitte des Servobereichs repräsentiert.

**Revendications**

1. Structure de moule pour impression en creux comprenant :

un substrat en forme de disque ayant sur une surface de celui-ci des motifs concavo-convexes dans une zone de données et dans une zone d'asservissement, dans laquelle le motif concavo-convexe dans la zone de données est formé en formant une pluralité de parties convexes le long de circonférences concentriques sur la surface du substrat en forme de disque, et le motif concavo-convexe dans la zone d'asservissement est formé en formant radialement des arêtes d'une pluralité de parties convexes sur la surface du substrat en forme de disque, dans laquelle la structure de moule pour impression en creux est configurée pour transférer le motif concavo-convexe sur une couche de résist pour impression en creux, qui est composée d'une composition de résist pour impression en creux formée sur un substrat de support d'enregistrement magnétique en forme de disque, en pressant les motifs concavo-convexes dans la zone de données et dans la zone d'asservissement contre la couche de résist pour impression en creux, et

dans lequel un motif factice est formé au niveau d'un bord circonférentiel intérieur et/ou d'un bord circonférentiel extérieur du motif concavo-convexe dans la zone d'asservissement par rapport au centre du substrat en forme de disque de la structure de moule pour impression en creux, le motif factice s'étendant radialement à partir d'un bord circonférentiel intérieur et/ou d'un bord circonférentiel extérieur d'une zone de formation de motif sur le substrat de support d'enregistrement magnétique,

dans laquelle la dimension de régions du motif factice dans une direction radiale sur la structure de moule pour impression en creux est dans la plage de 0,1 mm à 1,0 mm.

2. Structure de moule pour impression en creux selon la revendication 1, dans laquelle la largeur du motif concavo-convexe dans la zone d'asservissement le long de la circonférence la plus extérieure (WO) est plus grande que la largeur du motif concavo-convexe dans la zone d'asservissement le long de la circonférence la plus intérieure (WI).

3. Structure de moule pour impression en creux selon l'une quelconque des revendications 1 ou 2, dans laquelle le rapport de la largeur du motif concavo-convexe dans la zone d'asservissement le long de la circonférence la plus extérieure (WO) sur la largeur du motif concavo-convexe dans la zone d'asservissement le long de la circonférence la plus intérieure (WI) (W:W = WO/WI) est dans la plage de 1,5 à 2,8.

4. Structure de moule pour impression en creux selon l'une quelconque des revendications 1 à 3, dans laquelle le nombre (N) de parties convexes ou de parties concaves de la zone d'asservissement est dans la plage de 60 à 300.

5. Procédé d'impression en creux comprenant :

le transfert d'un motif concavo-convexe sur une couche de résist pour impression en creux formée sur un substrat de support d'enregistrement magnétique, en pressant la structure de moule pour impression en creux selon l'une quelconque des revendications 1 à 4 contre la couche de résist pour impression en creux.

6. Procédé d'impression en creux selon la revendication 5, dans laquelle des conditions pour le procédé d'impression en creux satisfont à l'Expression Mathématique 1 suivante :

$$0{,}001 \leq P/NW < 0{,}45 \qquad \text{Expression Mathématique 1}$$

dans laquelle P représente la viscosité de la composition de résist pour impression en creux en mPa·s, W représente le rapport de la largeur du motif concavo-convexe dans la zone d'asservissement le long de la circonférence la plus extérieure (WO) sur la largeur du motif concavo-convexe dans la zone d'asservissement le long de la circonférence la plus intérieure (WI) (W = WO/WI), et N représente le nombre de parties convexes ou de parties concaves de la zone d'asservissement.

7. Procédé d'impression en creux selon l'une quelconque des revendications 5 et 6, dans lequel la largeur du motif concavo-convexe dans la zone d'asservissement le long de la circonférence la plus extérieure (WO) est plus grande que la largeur du motif concavo-convexe dans la zone d'asservissement le long de la circonférence la plus intérieure (WI).

8. Procédé d'impression en creux selon l'une quelconque des revendications 5 à 7, dans lequel le rapport de la largeur du motif concavo-convexe dans la zone d'asservissement le long de la circonférence la plus extérieure (WO) sur la largeur du motif concavo-convexe dans la zone d'asservissement le long de la circonférence la plus intérieure (WI) (W:W = WO/WI) est dans la plage de 1,5 à 2, 8.

9. Procédé d'impression en creux selon l'une quelconque des revendications 5 à 8, dans lequel le nombre (N) de parties convexes ou de parties concaves de la zone d'asservissement est dans la plage de 60 à 300.

10. Procédé pour fabriquer un support d'enregistrement magnétique qui comprend

le transfert d'un motif concavo-convexe sur une couche de résist pour impression en creux formée sur un substrat de support d'enregistrement magnétique, en pressant une structure de moule pour impression en creux selon l'une quelconque des revendications 1 à 4 contre la couche de résist pour impression en creux,

la formation sur une première zone d'une couche magnétique d'une partie de motif magnétique d'une zone de données correspondant au motif concavo-convexe dans une zone de données formée sur la structure de moule pour impression en creux et la formation sur une seconde zone de la couche magnétique d'une partie de motif magnétique d'une zone d'asservissement formée sur la structure de moule pour impression en creux en attaquant les première et seconde zones de la couche magnétique formée sur une surface du substrat de support d'enregistrement magnétique en utilisant en tant que masque la couche de résist pour impression en creux sur laquelle un motif concavo-convexe a été transféré, et

la formation d'une partie de motif non magnétique en noyant une matière non magnétique dans une partie concave formée sur la couche magnétique, et

dans lequel la largeur de la partie de motif magnétique de la zone d'asservissement le long de la circonférence la plus extérieure (WO) est plus grande que la largeur de la partie de motif magnétique de la zone d'asservissement le long de la circonférence la plus intérieure (WI).

11. Procédé pour fabriquer un support d'enregistrement magnétique selon la revendication 10,

dans lequel le rapport de la largeur de la partie de motif magnétique de la zone d'asservissement le long de la circonférence la plus extérieure (WO) sur la largeur de la partie de motif magnétique de la zone d'asservissement le long de la circonférence la plus intérieure (WI) (W:W = WO/WI) est dans la plage de 1,5 à 2, 8.

12. Procédé pour fabriquer un support d'enregistrement magnétique selon l'une quelconque des revendications 10 et 11, dans lequel le nombre de parties de motif magnétique de la zone d'asservissement (N) est dans la plage de 60 à 300.

13. Procédé pour fabriquer un support d'enregistrement magnétique selon l'une quelconque des revendications 10 à 12, dans lequel les parties de motif magnétique de la zone d'asservissement sont un motif d'asservissement.

14. Procédé pour fabriquer un support d'enregistrement magnétique selon l'une quelconque des revendications 10 à 13, dans lequel le support d'enregistrement magnétique satisfait à l'Expression Mathématique 1 suivante :

$$0,001 \leq P/NW < 0,45 \qquad \text{Expression Mathématique 1}$$

dans laquelle P est en mPa·s et représente la viscosité de la composition de résist pour impression en creux, W représente le rapport de la largeur de la partie de motif magnétique de la zone d'asservissement le long de la circonférence la plus extérieure (WO) sur la largeur de la partie de motif magnétique de la zone d'asservissement le long de la circonférence la plus intérieure (WI) (W = WO/WI), et N représente le nombre de parties de motif magnétique de la zone d'asservissement.

# FIG. 1

# FIG. 2

# FIG. 3A

# FIG. 3B

# FIG. 4

**EP 2 037 453 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004221465 A
- JP 2006120299 A
- JP 2005071487 A